# EUROPÄISCHE PATENTSCHRIFT

(11) **EP 2 747 537 B1**
(45) Veröffentlichungstag und Bekanntmachung des Hinweises auf die Patenterteilung: **04.09.2019**
(21) Anmeldenummer: 13005390.3
(22) Anmeldetag: 15.11.2013
(51) Int. Cl.: H05K 13/04

(54) **Vorrichtung zum Bestücken von Substraten mit elektrischen Bauelementen**
Device for populating substrates with electrical components
Dispositif destiné à implanter des substrats avec des composants électriques

(30) Priorität: 21.12.2012 DE 102012025425
(43) Veröffentlichungstag der Anmeldung: 25.06.2014
(73) Patentinhaber: MIMOT GmbH, 79539 Lörrach (DE)
(72) Erfinder: MEHDIANPOUR, Mohammad, 81829 München (DE)
(74) Vertreter: Müller Hoffmann & Partner

(56) Entgegenhaltungen:
- EP-A1- 1 895 830
- DE-B3-102005 004 618
- DE-B3-102006 008 746
- JP-A- 2011 238 887
- US-A1- 2005 257 638

## Beschreibung

Die Erfindung bezieht sich auf eine Vorrichtung zum Bestücken von Substraten mit elektrischen Bauelementen mit einem stationären Grundrahmen und mit einem in einer Querrichtung verschiebbaren länglichen Führungsarm mit einer Längsführung für einen darin verschiebbar gelagerten Bearbeitungskopf, wobei der Führungsarm an einem sich in der Querrichtung erstreckenden Rahmenteil des Grundrahmens in zumindest einem Querlager verschiebbar ist, das eine am Rahmenteil vorgesehene Laufbahn und am Führungsarm befestigte Lagerelemente aufweist, wobei der Führungsarm mittels zumindest eines dem Querlager benachbarten, einseitig wirkenden elektrischen Linearmotors antreibbar ist, der aus einer sich in der Querrichtung erstreckenden flachen stationären Magnetbahn und einem über dieser verschiebbaren Spulenteil gebildet ist, wobei die mit Permanentmagneten versehene Magnetbahn am Rahmenteil angeordnet und das Spulenteil am Führungsarm befestigt ist, wobei zwischen dem Spulenteil und den Permanentmagneten eine magnetische Anzugskraft wirkt.

Durch die EP 1895830 A1 ist eine derartige Vorrichtung bekannt geworden, bei der der Führungsarm an seinen beiden Enden mittels je eines Linearmotors angetrieben wird und bei der neben den Linearmotoren jeweils ein Querlager vorgesehen ist. Die Laufbahnen sind hier durch an den Rahmenteilen befestigte Führungsschienen gebildet, an denen die am Führungsarm befestigten schlittenartigen Lagerelemente geführt sind. Die hohe magnetische Anzugskraft zwischen den Permanentmagneten der Magnetbahn und den Eisenkernen des Spulenteils wird zur Schonung der Linearführung durch einen permanentmagnetischen Streifen reduziert, der unterhalb der Magnetbahn am Führungsarm befestigt ist und der Anzugskraft entgegenwirkt. Die Magnet- und Lagerkräfte verursachen im Führungsarm eine Biegespannung, die eine entsprechend hohe Biegesteifigkeit erfordert. Durch Abweichungen in der Parallelität und Geradlinigkeit der Führungsschienen sowie durch thermische Einflüsse, z.B. durch die sich erwärmenden Spulenteile, können am Führungsarm Abstands- und Winkelabweichungen zwischen den Führungsschienen und den Lagerelementen und entsprechende Verspannungen auftreten, die die Führung erheblich belasten.

Durch die EP 940229 A ist eine Bestückvorrichtung bekannt geworden, bei der der Führungsarm an beiden Enden in quer gerichteten Linearführungen gelagert und durch Spindeln angetrieben ist. Zum Ausgleich der Abstands-Winkelabweichungen ist zwischen einem der schlittenartigen Lagerelemente und dem Führungsarm ein Festkörpergelenk vorgesehen. Die Beweglichkeit der großflächigen Plattenelemente erfordert eine kleinflächige punktartige Abstützung im zentralen Gelenkbereich. Ein Verkippen des Führungsarms um eine Längsachse durch höhenversetzte Antriebs- und Massenkräfte kann dadurch nicht sicher vermieden werden.

Aus der US 2005/257638 A1 ist ein Linearantrieb für eine Bestückvorrichtung bekannt, mit dessen Hilfe ein Führungsarm in einer Querrichtung bewegt werden kann.

Der Erfindung liegt die Aufgabe zugrunde, eine einfache kompakte Anordnung der Führungs-und Antriebselemente mit günstigen Kraft- und Hebelverhältnissen zu schaffen.

Diese Aufgabe wird durch eine Vorrichtung mit den Merkmalen von Anspruch 1 gelöst. Vorteilhafte Weiterentwicklungen sind in den abhängigen Ansprüchen definiert.

Durch die übereinander und sich überdeckenden Führungs- und Motorteile bei der Vorrichtung nach Anspruch 1 wird die Längserstreckung diese Teile erheblich verringert. Das Rahmenteil kann unmittelbar am Grundrahmen ausgeformt oder auch an diesen angesetzt sein. Die am Rahmenteil eingesparte Länge ermöglicht es, bei gleichbleibender Außenlänge der Vorrichtung die Führungslänge des Bearbeitungskopfes am Führungsarm und somit den Arbeitsbereich der Vorrichtung entsprechend zu vergrößern.

Der Längsabstand zwischen dem Querlager und dem Linearmotor wird erheblich verringert, so dass das resultierende Biegemoment entsprechend niedrig wird und der Führungsarm weniger biegesteif ausgebildet werden kann. Auf einen zusätzlichen Gegenmagneten kann verzichtet werden.

Bei Weiterbildungen der Erfindung wird die kompakte Anordnung der Lager- und Führungselemente in einfacher Weise realisiert. Insbesondere sind die zu bearbeitenden Funktionsflächen gut zugänglich und können im Hinblick auf ihre Parallelität genau gefertigt werden.

Durch eine Weiterbildung kann die Führungslänge und Stützlänge des Lagerelementpaares vergrößert werden.

Eine Weiterbildung ermöglicht die kompakte Bauweise mit den günstigen Kräfteverhältnissen auch auf der gegenüberliegenden Seite des Führungsarmes.

Bei einer Variante wird eine Zwei-Punkt Abstützung des Führungsarmes an den Lagerelementen in großem Abstand bei voller Auslenkbarkeit in der Längsrichtung und in der Winkelorientierung mit einfachsten konstruktiven Mitteln von geringem Raumbedarf ermöglicht. Die Stützkugeln werden unter der Anzugskraft des Linearmotors fest in die Führungsnuten gedrückt. Sie übertragen die Magnetkräfte definiert spielfrei auf die Linearführung ohne jede Verspannung oder Verkantung. Durch die weit beabstandete Anordnung der Stützkugeln in der Querrichtung wird sichergestellt, dass die aus dem Höhenunterschied der Antriebs- und Massenkräfte resultierenden Kippmomente sicher abgefangen werden, ohne dass die Gefahr des Abhebens besteht.

Die flachen Ausgleichselemente bei einer weiteren Ausführungsform benötigen wenig Einbauraum und lassen sich leicht herstellen und einbauen.

Durch die bei einer Variante vorgesehene Teilung eines der Ausgleichselemente in zwei getrennte Teilelemente können die oberen und unteren Führungsnuten in ihrem Seitenabstand bei der Montage genau aufeinander eingestellt werden.

Bei einer Weiterbildung können die Merkmale in besonders vorteilhafter Weise kombiniert werden. Bei einer Anordnung der Querführung neben dem Linearmotor besteht die Gefahr, dass sich der Führungsarm soweit durchbiegt, dass sich die oberen Führungsnuten gegen die unteren neigen und öffnen. Dadurch könnten die Kugeln in der Längsrichtung aus ihrer Mittelposition in der Art eines Kirschkerneffekts bis zu einer Begrenzung herauswandern und ihre freie Beweglichkeit verlieren. Bei der sich überdeckenden Anordnung der Querführung und des Linearmotors sind die Biegespannungen so gering, dass ein solcher Störeffekt nicht auftreten kann.

Durch eine Weiterbildung wird die kompakte Anordnung der Lager- und Führungselemente in einfacher Weise realisiert.

Im Folgenden wird die Erfindung anhand eines in der Zeichnung dargestellten Ausführungsbeispieles näher erläutert. Es zeigen:
- Figur 1: eine perspektivische Ansicht einer Vorrichtung zum Bestücken von Substraten mit elektrischen Bauelementen,
- Figur 2: die vergrößerte Einzelheit II in Figur 1,
- Figur 3: einen Teilschnitt durch die Vorrichtung entlang der Linie III-III in Figur 1,
- Figur 4: eine Seitenansicht der Teile nach Figur 3 mit einem Teilschnitt entlang der Linie IV-IV,
- Figur 5: die vergrößerte Einzelheit V in Figur 3.

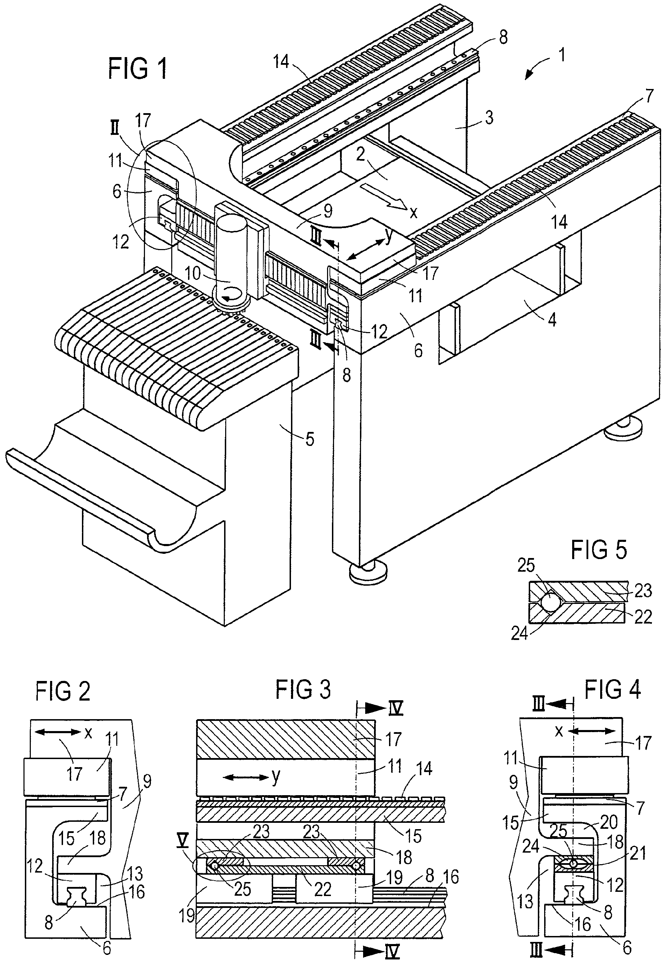

Nach Figur 1 weist eine Vorrichtung 1 zum Bestücken von als Leiterplatten ausgebildeten Substraten 2 mit elektrischen Bauelementen einen Grundrahmen 3 auf, an dem eine waagerechte lineare Transportstrecke 4 für die Substrate 2 angebracht ist, die gemäß dem gezeigten Richtungspfeil in einer Längsrichtung x durch die Vorrichtung verschiebbar sind und die in einem Bestückbereich der Vorrichtung auf der Transportstrecke 4 in der gezeigten Position fixierbar sind. Die Bauelemente sind von einer Bereitstelleinrichtung 5 abholbar, die in nicht näher dargestellter Weise wechselbar an den Grundrahmen 3 angedockt ist.

Der Grundrahmen 3 weist oberhalb der Transportstrecke 4 in deren Endabschnitten länglich gestreckte vorzugsweise separate Rahmenteile 6 auf, die sich quer zur Längsrichtung x erstrecken. Die zueinander parallelen Rahmenteile 6 sind auf ihren Oberseiten mit Magnetbahnen 7 von einseitig wirkenden Linearmotoren und auf den einander zugewandten Innenseiten mit Führungsschienen 8 versehen, in denen ein sich in der Längsrichtung x erstreckender Führungsarm 9 mittels der Linearmotoren in einer waagerechten Querrichtung y senkrecht zur Längsrichtung x verschiebbar ist. Der Führungsarm 9 ist mit Antriebs- und Führungsmitteln für einen in der Längsrichtung x waagerecht verschiebbaren Bearbeitungskopf 10 zum Handhaben der Bauelemente versehen.

Über den Magnetbahnen 7 sind am Führungsarm 9 Spulenteile 11 befestigt, die zusammen mit den Magnetbahnen 7 die Linearmotoren bilden. Der Führungsarm 9 trägt ferner Lagerelemente 12, die seitlich spielfrei an den Führungsschienen 8 gelagert sind und mit diesen jeweils ein Querlager in Form einer Linearführung bilden.

Die Rahmenteile 6 und die jeweils benachbarten Stirnenden des Führungsarms 9 weisen in spiegelbildlicher Anordnung wechselseitig ineinander greifende, in die Längsrichtung x ragende Vorsprünge und Vertiefungen auf, die sich in der Querrichtung y erstrecken an bzw. in denen die Elemente des Linearmotors und des Querlagers angeordnet sind.

In den Figuren 2 bis 5 sind diese Strukturen vergrößert dargestellt. Die folgenden Beschreibungsabschnitte beziehen sich der Einfachheit halber auf eine Seite der Vorrichtung in einem Endbereich des Führungsarms, sollen aber auch für die spiegelbildlich ausgebildete Gegenseite gelten.

Das Rahmenteil 6 weist auf seiner dem Führungsarm 10 zugewandten Innenseite eine in der Querrichtung y durchgehende Ausnehmung 13 auf, die dem Rahmenteil einen u-förmigen Querschnitt verleiht mit zwei zum Führungsarm 9 weisenden Schenkeln. Die Magnetbahn 7 ist auf der waagerechten Oberseite des Rahmenteils 6 befestigt und mit streifenförmigen Permanentmagneten 14 belegt, wobei die Innenseiten der Magnetbahn 7 und des oberen Schenkels 15 bündig angeordnet sind, der die Magnetbahn in voller Breite trägt. Der untere Schenkel bildet auf seiner der Magnetbahn 7 zugewandten Oberseite eine Stützschulter 16, auf der die Führungsschiene 8 befestigt ist.

Das Stirnende des Führungsarms 9 weist eine F-förmige Kontur auf mit einem in der Längsrichtung x lang vorstehenden oberen Stützschenkel 17 und einem kürzeren mittleren Schenkel. Der Stützschenkel 17 erstreckt sich annähernd bis zur Außenseite des Rahmenteils 6 und trägt an seiner der Magnetbahn 7 zugewandten Unterseite das Spulenteil 11. Eine zwischen diesem und den Permanentmagneten 14 auf den Führungsarm 9 wirkende Anzugskraft ist nach unten gerichtet. Der in die Ausnehmung 13 ragende mittlere Schenkel ist oberhalb der Stützschulter 16 angeordnet und dient als Stützsteg 18 für das auf seiner Unterseite angeordnete Lagerelement 12, das durch zwei fest miteinander verbundene, die Führungsschiene umgreifende Schlittenteile 19 gebildet ist.

Dabei bilden der obere Stützschenkel 17 und der Stützsteg 18 eine Vertiefung 20, in die der obere Schenkel 15 des Rahmenteils 6 hinein ragt. Die Ausnehmung 13 ist so tief, dass sie das Lagerelement 12 in voller Breite aufnimmt. Dadurch wird die Linearführung vollständig vom Linearmotor überdeckt und benötigt keine zusätzliche Baulänge der Vorrichtung. Der Mittenabstand zwischen dem Linearmotor und der Linearführung in der Längsrichtung x ist so gering, dass die hohen Anzugs- und Stützkräfte nur ein sehr geringes Biegemoment am Führungsarm 9 ergeben, so dass eine entsprechende Durchbiegung vernachlässigbar ist.

Die folgenden Beschreibungsteile beziehen sich im Wesentlichen auf das in Figur 1 rechts dargestellte Rahmenteil 6 und das diesem zugewandte Stirnende des Führungsarms 9. Die beiden Vorrichtungsseiten unterscheiden sich vor allem dadurch, dass das linke Lagerelement 12 unmittelbar fest mit dem linken Stützsteg 18 verbunden ist und dass zwischen dem rechten Stützsteg 18 und dem rechten Lagerelement 12 ein Ausgleichslager 21 angeordnet ist, das die beiden Teile kinematisch fest verbindet, aber Längen- und Winkelabweichungen zwischen den beiden Führungsschienen spannungsfrei ausgleicht. Die beiden Stützstege 18 sind um die Dicke des Ausgleichslagers 21 höhenversetzt.

Das Ausgleichslager 21 besteht aus drei streifenförmigen flachen Ausgleichselementen 22, 23, von denen ein auf den Schlittenteilen 19 befestigtes unteres Ausgleichselement 22 sich über beide Schlittenteile erstreckt und diese fest miteinander verbindet. Es weist auf seiner dem Stützsteg 18 zugewandten Oberseite in seinen Endabschnitten zwei sich in der Längsrichtung x erstreckende v-förmige längenbegrenzte Führungsnuten 24 auf, in denen je eine Stützkugel 25 mittig einliegt. Am Stützsteg 18 sind zwei kurze getrennte obere Ausgleichselemente 23 mit je einer sich in der Längsrichtung x erstreckenden, nach unten offenen, v-förmigen Führungsnut 24 befestigt.

Durch die Trennung der oberen Ausgleichselemente 23 können diese so montiert werden, dass die oberen und unteren Führungsnuten einen exakt gleichgroßen Abstand in der Querrichtung y aufweisen. Dadurch liegen die beiden Stützkugeln 25 jeweils voll in den beiden Führungsnuten ein und übertragen die Bewegung des Führungsarms 9 spielfrei auf die Schlittenteile 19. Durch einen Höhenversatz zwischen den Antriebskräften des Linearmotors und dem Massenschwerpunkt des Führungsarms 9 entstehen an diesem Kippmomente. Der Abstand zwischen den Stützkugeln ist so groß dass auch bei maximaler Querbeschleunigung unter der Anzugskraft des Linearmotors beide Stützkugeln 25 belastet und voll im Eingriff bleiben.

Figur 5 zeigt einen vergrößerten Endbereich des Ausgleichslagers 20 mit den Stützkugeln 25 und den Führungsnuten 24. Der Durchmesser der Stützkugeln 25 und der Querschnitt der Führungsnuten 24 sind so bemessen, dass sich die oberen und unteren Ausgleichselemente 23 und 21 nicht berühren. Dadurch kann die gesamte Stützkraft nur über die Stützkugeln 25 definiert übertragen werden.

### Bezugszeichen

- x: Längsrichtung
- y: Querrichtung
- 1: Vorrichtung
- 2: Substrat
- 3: Grundrahmen
- 4: Transportstrecke
- 5: Bereitstelleinrichtung
- 6: Rahmenteil
- 7: Magnetbahn
- 8: Führungsschiene
- 9: Führungsarm
- 10: Bearbeitungskopf
- 11: Spulenteil
- 12: Lagerelement
- 13: Ausnehmung
- 14: Permanentmagnet
- 15: oberer Schenkel
- 16: Stützschulter
- 17: Stützschenkel
- 18: Stützsteg
- 19: Schlittenteil
- 20: Vertiefung
- 21: Ausgleichslager
- 22: unteres Ausgleichselement
- 23: oberes Ausgleichselement
- 24: Führungsnut
- 25: Stützkugel

## Patentansprüche

1. Vorrichtung (1) zum Bestücken von Substraten (2) mit elektrischen Bauelementen
mit einem stationären Grundrahmen (3) und
mit einem in einer Querrichtung (y) verschiebbaren länglichen Führungsarm (9) mit Antriebs- und Führungsmitteln für einen darin in einer Längsrichtung verschiebbar gelagerten Bearbeitungskopf (10),
wobei
der Führungsarm (9) am Grundrahmen (3) in zumindest einem Querlager verschiebbar ist, das eine an einem Rahmenteil (6) des Grundrahmens (3) vorgesehene Laufbahn (8) und ein daran gelagertes, am Führungsarm befestigtes Lagerelement (12) aufweist,
der Führungsarm (9) mittels eines dem Querlager benachbarten, einseitig wirkenden elektrischen Linearmotors antreibbar ist, der aus einer sich in der Querrichtung (y) erstreckenden flachen stationären Magnetbahn (7) und einem über dieser verschiebbaren Spulenteil (11) gebildet ist,
die mit Permanentmagneten (14) versehene Magnetbahn (7) an dem sich in der Querrichtung (y) erstreckenden Rahmenteil (6) angeordnet und das Spulenteil (11) am Führungsarm (9) befestigt ist,
zwischen dem Spulenteil (11) und den Permanentmagneten (14) eine magnetische Anzugskraft wirkt,
die Magnetbahn (7) und die Laufbahn (8) in der Richtung der Anzugskraft übereinander liegend angeordnet sind und sich in der Draufsicht in dieser Anzugsrichtung einander überdecken,
und wobei
das Rahmenteil (6) und das benachbarte Stirnende des Führungsarms (9) wechselseitig ineinander greifende, in die Längsrichtung ragende Vorsprünge und Vertiefungen aufweisen, die sich in der Querrichtung (y) erstrecken und an bzw. in denen die Elemente des Linearmotors und des Querlagers befestigt und angeordnet sind.

2. Vorrichtung nach Anspruch 1, **dadurch gekennzeichnet,**
**dass** die Permanentmagnete (14) auf einer waagerechten Oberseite des Rahmenteils (6) angeordnet sind,
**dass** in einem darunter liegenden Bereich des Rahmenteils (6) eine in die Richtung des Führungsarms (9) vorstehende, nach oben weisende Stützschulter (16) ausgebildet ist,
**dass** die Laufbahn des Querlagers als Führungsschiene (8) einer Linearführung ausgebildet und an der zur Magnetbahn(7) parallelen Stützschulter (16) befestigt ist,
**dass** der Führungsarm (9) einen oberen zum Linearmotor vorspringenden Stützschenkel (17) aufweist, an dessen der Magnetbahn (7) zugewandten Unterseite das Spulenteil (11) befestigt ist, und
**dass** der Führungsarm (9) oberhalb der Stützschulter (16) einen zum Rahmenteil (6) vorstehenden Stützsteg (18) aufweist, an dessen der Stützschulter (16) zugewandten Unterseite das an der Führungsschiene (8) seitlich spielfrei gelagerte Lagerelement (12) befestigt ist.

3. Vorrichtung nach Anspruch 2, **dadurch gekennzeichnet,**
**dass** das Lagerelement (12) aus zwei Schlittenteilen (19)gebildet ist, die in deren Verschieberichtung hintereinanderliegend am Stützsteg (18) befestigt sind.

4. Vorrichtung nach einem der vorhergehenden Ansprüche, **dadurch gekennzeichnet,**
**dass** am gegenüberliegenden Ende des Führungsarms (9) in annähernd spiegelbildlicher Ausbildung ein weiteres Rahmenteil (6) des Grundrahmens, ein weiterer Linearmotor und ein weiteres Querlager für den Führungsarm (9) vorgesehen ist.

5. Vorrichtung nach einem der vorhergehenden Ansprüche, **dadurch gekennzeichnet,**
**dass** zwischen dem Führungsarm (9) und dem Lagerelement (12) zwei in der Querrichtung (y) beabstandete Stützkugeln (25) vorgesehen sind, die die magnetische Anzugskraft des Linearmotors auf das Lagerelement (12) übertragen, dass die Stützkugeln (25) in sich in der Längsrichtung erstreckenden, z.B. v-förmigen Führungsnuten (24) gelagert sind, die paarweise mittelbar oder unmittelbar an dem Lagerelement (12) und am Führungsarm (9) derart ausgebildet sind, dass sie sich zueinander öffnen und die Stützkugeln (25) in der Querrichtung (y) spielfrei umschließen und
**dass** das weitere Lagerelement (12) fest mit dem Führungsarm (9) verbunden ist,

6. Vorrichtung nach Anspruch 5, **dadurch gekennzeichnet,**
**dass** die Nuten an den einander zugewandten Seiten von übereinanderliegenden Ausgleichselementen (22, 23) vorgesehen sind, die am Führungsarm (9) bzw. Lagerelement (12) befestigt sind und ein Ausgleichslager (21) bilden.

7. Vorrichtung nach Anspruch 6, **dadurch gekennzeichnet,**
**dass** das Lagerelement (12) aus zwei an der Führungsschiene (8) gelagerten Schlittenteilen (19) besteht,
**dass** eines der beiden Ausgleichselemente (22) die beiden Schlittenteile (19) überdeckt und an diesen befestigt ist und
**dass** am Führungsarm (9) zwei der getrennten oberen Ausgleichselemente (23) befestigt sind, die mit je einer der Führungsnuten (24) versehen sind.

## Claims

1. Device (1) for the fitting of substrates (2) with electrical structural elements with a stationary base frame (3), and
with a longitudinal guide arm (9) which can be moved in a transverse direction (y), with drive means and guide means for a processing head (10) mounted therein and capable of movement in a longitudinal direction,
wherein
the guide arm (9) can be moved on the base frame (3) in at least one transverse bearing, which comprises a movement track (8) provided at a frame part (6) of the base frame (3) and a bearing element (12) mounted thereon and secured to the guide arm,
the guide arm (9) can be driven by means of an electric linear motor, adjacent to the transverse bearing and taking effect on one side, which is formed from a flat stationary magnet track (7) extending in the transverse direction (y) and from a coil part (11) which can be moved over this said track,
the magnet track (7), provided with permanent magnets (14), arranged at which is the frame part (6) extending in the transverse direction (y) and the coil part (11) is secured to the guide arm (9),
a magnetic attraction force takes effect between the coil part (11) and the permanent magnets (14),
the magnet track (7) and the movement track (8) are arranged lying one above the other in the direction of the attraction force, and, in a view from above in this direction of attraction, cover one another,
and wherein
the frame part (6) and the adjacent face end of the guide arm (9) mutually engage into one another, and comprise projections projecting in the longitudinal direction and indentations extending in the transverse direction (y), and secured and arranged at or in these are the elements of the linear motor and of the transverse bearing.

2. Device according to claim 1, **characterised in**
**that** the permanent magnets (14) are arranged on a horizontal upper side of the frame part (6),
**that** in a region of the frame part (6) lying under this is formed a support shoulder (16), projecting in the direction of the guide arm (9) and pointing upwards,
**that** the movement track of the transverse bearing is configured as a guide rail (8) of a linear guide, and is secured at the support shoulder (16) parallel to the magnet track (7),
**that** the guide arm (9) comprises an upper support limb (17) projecting towards the linear motor, secured to the underside of which, facing towards the magnet track (7), is the coil part (11), and
**that** the guide arm (9) comprises, above the support shoulder (16), a support web (18) projecting towards the frame part (6), secured to the underside of which, facing towards the support shoulder (16), is the bearing element (12), mounted on the guide rail (8) such as to be free of play laterally.

3. Device according to claim 2, **characterised in**
**that** the bearing element (12) is formed from two carriage parts (19), which in their direction of movement are secured behind one another at the support web (18).

4. Device according to any one of the preceding claims, **characterised in**
**that** provided at the opposite end of the guide arm (9), in an approximately mirror-image configuration, is a further frame part (6) of the base frame, a further linear motor, and a further transverse bearing for the guide arm (9).

5. Device according to any one of the preceding claims, **characterised in**
**that**, provided between the guide arm (9) and the bearing element (12), are two support spheres (25) spaced at an interval in the transverse direction (y), which transfer the magnetic attraction force of the linear motor onto the bearing element (12), that the support spheres (25) are mounted in guide slots (24) extending in the longitudinal direction, for example in V-shape, which are formed in pairs indirectly or directly at the bearing element (12) and at the guide arm (9) in such a way that they are open towards each other and surround the support spheres (25) in the transverse direction (y) free of play, and
**that** the further bearing element (12) is securely connected to the guide arm (9).

6. Device according to claim 5, **characterised in**
the slots are provided at the sides facing one another of compensation elements (22,23) lying above one another, which are secured to the guide arm (9) and bearing element (12) respectively, and form a compensation bearing (21).

7. Device according to claim 6, **characterised in**
**that** the bearing element (12) consists of two carriage parts (19) mounted on the guide rail (8),
**that** one of the two compensation elements (22) covers the two carriage parts (19) and is secured to them, and
**that** secured to the guide arm (9) are two of the separated upper compensation elements (23), which are each provided with one of the guide slots (24).

## Revendications

1. Dispositif (1) pour garnir des substrats (2) avec des composants électriques,
avec un châssis de base stationnaire (3) et
avec un bras de guidage (9) oblong, coulissant dans une direction transversale (y), avec des moyens d'entraînement et de guidage pour une tête de traitement (10) montée coulissante dans celui-ci dans une direction longitudinale,
dans lequel
le bras de guidage (9) est apte à coulisser sur le châssis de base (3) dans au moins un montage transversal qui présente une voie de roulement (8) prévue sur un élément de châssis (6) du châssis de base (3), et un élément de montage (12) monté sur celle-ci et fixé au bras de guidage,
le bras de guidage (9) est apte à être entraîné à l'aide d'un moteur linéaire électrique, voisin du montage transversal et agissant unilatéralement, qui se compose d'une voie magnétique stationnaire (7) plate s'étendant dans la direction transversale (y), et d'un élément à bobine (11) coulissant au-dessus de celle-ci,
la voie magnétique (7) pourvue d'aimants permanents (14) est disposée sur l'élément de châssis (6) s'étendant dans la direction transversale (y), et l'élément à bobine (11) est fixé au bras de guidage (9),
entre l'élément à bobine (11) et les aimants permanents (14) agit une force d'attraction magnétique,
la voie magnétique (7) et la voie de roulement (8) sont superposées dans la direction de la force d'attraction et se recouvrent dans cette direction d'attraction, vues de dessus,
et dans lequel
l'élément de châssis (6) et l'extrémité frontale voisine du bras de guidage (9) présentent des saillies s'interpénétrant en alternance et dépassant dans la direction longitudinale, et des creux qui s'étendent dans la direction transversale (y) et auxquels ou dans lesquels sont fixés et disposés les éléments du moteur linéaire et du montage transversal.

2. Dispositif selon la revendication 1, **caractérisé**
**en ce que** les aimants permanents (14) sont disposés sur un côté supérieur horizontal de l'élément de châssis (6),
**en ce que** dans une zone de l'élément de châssis (6) située au-dessous est formé un épaulement d'appui (16) dépassant en direction du bras de guidage (9) et dirigé vers le haut,
**en ce que** la voie de roulement du montage transversal est formée comme un rail de guidage (8) d'un guidage linéaire et est fixée à l'épaulement d'appui (16) parallèle à la voie magnétique (7),
**en ce que** le bras de guidage (9) présente une branche d'appui supérieure (17) saillant vers le moteur linéaire, sur le côté inférieur, tourné vers la voie magnétique (7), duquel est fixé l'élément à bobine (11), et
**en ce que** le bras de guidage (9) présente au-dessus de l'épaulement d'appui (16) un rebord d'appui (18), dépassant vers l'élément de châssis (6), sur le côté inférieur, tourné vers l'épaulement d'appui (16), duquel est fixé l'élément de montage (12) monté sans jeu latéral sur le rail de guidage (8).

3. Dispositif selon la revendication 2, **caractérisé**
**en ce que** l'élément de montage (12) est formé de deux éléments de chariot (19) qui sont fixés l'un derrière l'autre, dans leur sens de coulissement, au rebord d'appui (18).

4. Dispositif selon l'une des revendications précédentes, **caractérisé**
**en ce que** sur l'extrémité opposée du bras de guidage (9) sont formés, approximativement en miroir, un autre élément de châssis (6) du châssis de base, un autre moteur linéaire et un autre montage transversal pour le bras de guidage (9).

5. Dispositif selon l'une des revendications précédentes, **caractérisé**
**en ce qu'**il est prévu, entre le bras de guidage (9) et l'élément de montage (12), deux billes d'appui (25) espacées dans la direction transversale (y), qui transmettent la force d'attraction magnétique du moteur linéaire à l'élément de montage (12),
**en ce que** les billes d'appui (25) sont montées dans des rainures de guidage (24), par exemple en forme de v, qui s'étendent dans la direction longitudinale et qui sont formées par paires indirectement ou directement sur l'élément de montage (12) et sur le bras de guidage (9) de telle sorte qu'elles s'ouvrent l'une vers l'autre et entourent les billes d'appui (25) sans jeu dans la direction transversale (y), et
**en ce que** l'autre élément de montage (12) est relié de manière fixe au bras de guidage (9).

6. Dispositif selon la revendication 5, **caractérisé**
**en ce que** les rainures sont prévues sur les côtés, tournés l'un vers l'autre, d'éléments d'équilibrage (22, 23) superposés qui sont fixés au bras de guidage (9) ou à l'élément de montage (12) et forment un montage d'équilibrage (21).

7. Dispositif selon la revendication 6, **caractérisé**
**en ce que** l'élément de montage (12) se compose de deux éléments de chariot (19) montés sur le rail de guidage (8),
**en ce que** l'un des éléments d'équilibrage (22) couvre les deux éléments d'équilibrage (19) et est fixé à ceux-ci, et
**en ce qu'**au bras de guidage (9) sont fixés deux des éléments d'équilibrage supérieurs (23) séparés qui sont pourvus chacun de l'une des rainures de guidage (24).
